# EUROPEAN PATENT APPLICATION

(11) **EP 4 379 805 A1**
(43) Date of publication of application: **05.06.2024**
(21) Application number: 22849734.3
(22) Date of filing: 30.06.2022
(51) Int. Cl.: H01L 27/15, H01L 25/075, H01L 27/12, H01L 33/62, H01L 33/36

(54) **DISPLAY DEVICE COMPRISING SEMICONDUCTOR LIGHT EMITTING ELEMENT**

(30) Priority: 30.07.2021 KR 20210100867
(71) Applicant: LG Electronics Inc., Yeongdeungpo-gu Seoul 07336 (KR); LG Display Co., Ltd., Seoul 07336 (KR)
(72) Inventor: BANG, Kyuhyun, Seoul 06772 (KR); LEE, Sul, Paju-si Gyeonggi-do 10845 (KR); JANG, Hun, Paju-si Gyeonggi-do 10845 (KR); KIM, Minseok, Paju-si Gyeonggi-do 10845 (KR)
(74) Representative: Vossius & Partner Patentanwälte Rechtsanwälte mbB
(86) International application number: PCT/KR2022/009402
(87) International publication number: WO 2023/008757

(57) **Abstract**

A display device according to an embodiment includes a substrate, a first assembly wiring and second assembly wiring alternately arranged on the substrate and spaced apart from each other, an insulating layer disposed on the first assembly wiring or the second assembly wiring, a planarization layer disposed on the first assembly wiring and the second assembled wiring and having an opening, and a light emitting device disposed inside the opening and the first electrode overlapping the first assembly wiring and the second assembly wiring.

## Description

### [Technical Field]

The embodiment relates to a display device, and more specifically, to a display device using a semiconductor light emitting device.

### [Background Art]

There are organic light emitting displays (OLED) that emit light on their own, liquid crystal displays (LCD) and micro-LED displays that require a separate light source in the display devices used in computer monitors, TVs, mobile phones, etc.

Micro-LED display is a display that uses micro-LED, a semiconductor light emitting device with a diameter or cross-sectional area of 100µm or less, as a display device.

Micro-LED displays use micro-LED, a semiconductor light emitting device, as a display device, so they have excellent performance in many characteristics such as contrast ratio, response speed, color gamut, viewing angle, brightness, resolution, lifespan, luminous efficiency, and luminance.

In particular, the micro-LED display has the advantage of being able to freely adjust the size and resolution and implement a flexible display because the screen may be separated and combined in a modular manner.

However, because large micro-LED displays require more than millions of micro-LEDs, there is a technical problem that makes it difficult to quickly and accurately transfer micro-LEDs to the display panel. Meanwhile, methods for transferring a semiconductor light emitting device to a substrate include a pick and place process, a laser lift-off method, or a self-assembly method.

Among these, the self-assembly method is a method in which the semiconductor light emitting device finds its assembly position within the fluid on its own, and is an advantageous method for implementing a large-screen display device.

Meanwhile, when transferring a light emitting device in a fluid, a problem arises where the assembly wiring is corroded by the fluid. Corrosion of the assembly wiring may cause an electrical short circuit and cause assembly defects.

Additionally, when a step is formed in the assembly wiring, the wiring electrode is vulnerable in the step area, which may cause problems with external shock or damage during assembly. Therefore, there is a need for technology that may protect wiring electrodes in step areas.

### [Disclosure]

### [Technical Problem]

The technical object of the embodiment is to provide a display device that improves the assembly rate of light-emitting devices by implementing assembly wiring in various forms.

Additionally, the technical object of the embodiment is to provide a display device that prevents corrosion of assembly wiring.

In addition, the technical object of the embodiment is to provide a display device in which steps are prevented from occurring in assembly wiring.

Additionally, the technical object of the embodiment is to provide a display device that may protect the assembly wiring in the step area when a step is formed in the assembly wiring.

The objects of the embodiment are not limited to the tasks mentioned above and include what may be understood from the specification.

### [Technical Solution]

A display device including a semiconductor light emitting device according to an embodiment includes a substrate, first assembly wiring and second assembly wiring alternately arranged on the substrate and spaced apart from each other,

An insulating layer disposed on the first assembly wiring or the second assembly wiring,

The light emitting device disposed on the first assembly wiring and the second assembly wiring, a planarization layer having an opening, and disposed inside the opening, and a first electrode overlapping the first assembly wiring and the second assembly wiring, and the first assembly wiring and the second assembly wiring may be disposed on the same layer.

The first electrode may be bonded to one of the first assembly wiring and the second assembly wiring.

The first assembly wiring includes a first conductive layer disposed on the substrate and a first clad layer in contact with the first conductive layer, and the second assembly wiring includes a second conductive layer disposed on the substrate and a second clad layer in contact with the second conductive layer.

The first electrode may be in contact with the second clad layer.

The first conductive layer and the second conductive layer may include the same material, and the first clad layer and the second clad layer may include the same material.

The first conductive layer and the second conductive layer may overlap the planarization layer, and a portion of each of the first clad layer and the second clad layer may be disposed inside the opening.

The first clad layer and the first conductive layer may be in contact with each other through the insulating layer, and the second clad layer and the second conductive layer may be in contact with each other through the insulating layer.

In an embodiment, the first clad layer may be disposed under the first conductive layer, and the second clad layer may be disposed under the second conductive layer.

The first clad layer covers the first conductive layer on the first conductive layer,

The second clad layer may cover the second conductive layer on the second conductive layer.

The embodiment further includes a first insulating layer interposed between the side surface of the planarization layer overlapping the first conductive layer and the opening.

The first clad layer and the second clad layer vertically overlap, and the second clad layer may include an electrode hole in a region that vertically overlaps the first clad layer.

In addition, a display device including a semiconductor light emitting device according to an embodiment includes a substrate, first assembly wiring and second assembly wiring alternately arranged on the substrate and spaced apart from each other, an insulating layer disposed on the first assembly wiring or the second assembly wiring, a planarization layer disposed on the first assembly wiring and the second assembly wiring and having an opening, a light emitting device disposed inside the opening, wherein a first electrode overlaps the first assembly wiring and the second assembly wiring, and a step protection layer overlapping with the first assembly wiring or the second assembly wiring disposed below the insulating layer.

In an embodiment, the step protective layer may overlap the planarization layer.

The first assembly wiring includes a first conductive layer and a first clad layer electrically connected to the first conductive layer,

The second assembly wiring includes a second conductive layer and a second clad layer electrically connected to the second conductive layer,

The first conductive layer and the first clad layer may include different materials, and the second conductive layer and the second clad layer may include different materials.

Both the first clad layer and the second clad layer may extend inside the opening.

The first clad layer may cover the first conductive layer, and the second clad layer may cover the second conductive layer.

The second conductive layer may include the same material as the step protective layer.

The first clad layer may be disposed below the first conductive layer, and the second clad layer may be disposed below the second conductive layer.

The step protective layer may cover the top and side surfaces of the first conductive layer.

The embodiment may further include a first insulating layer interposed between the side surface of the planarization layer overlapping the first conductive layer and the opening.

The first clad layer and the second clad layer vertically overlap, and the second clad layer may include an electrode hole in a region that vertically overlaps the first clad layer.

### [Advantageous Effects]

According to an embodiment, by arranging the cladding layer of the assembly wiring under the conductive layer, it is possible to prevent the occurrence of steps due to the thickness of the conductive layer, and the thickness of the passivation layer arranged to cover the clad layer may also be kept constant, which has the technical effect of facilitating self-assembly of the light-emitting device through a plurality of assembly wirings.

In addition, in the embodiment, when the first assembly wiring and the second assembly wiring are arranged in different layers, a step protective layer is disposed on the assembly wiring placed below, so that the embodiment has a technical effect of reducing corrosion of assembly wiring and self-assembly defects.

In addition, the embodiment has the technical effect of preventing corrosion of the conductive layer by using a clad layer that is resistant to corrosion.

In addition, the embodiment has the technical effect of protecting the assembly wiring by placing an insulating layer in the step area when a step occurs in the assembly wiring.

In addition, the embodiment has the technical effect of improving the assembly force of the light emitting device by arranging the first assembly wiring and the second assembly wiring to overlap vertically.

The effects according to the embodiment are not limited to the contents exemplified above, and more diverse effects are included in the specification.

### [Description of Drawings]

FIG. 1 is a schematic plan view of a display device according to an embodiment.
FIG. 2 is a schematic enlarged plan view of a display device according to an embodiment.
FIG. 3 is a cross-sectional view taken along line III-III' in FIG. 2.
FIGS. 4A and 4B are process diagrams for explaining a manufacturing method of a display device according to an embodiment.
FIG. 5 is a cross-sectional view of a display device according to a second embodiment.
FIG. 6 is a cross-sectional view of a display device according to a third embodiment.
FIG. 7 is a cross-sectional view of a display device according to the fourth embodiment.
FIG. 8 is a cross-sectional view of a display device according to the fifth embodiment.
FIG. 9 is a cross-sectional view of a display device according to the sixth embodiment.
FIG. 10 is a cross-sectional view of a display device according to the seventh embodiment.
FIG. 11 is a cross-sectional view of a display device according to the eighth embodiment.
FIG. 12 is an enlarged perspective view of part of the eighth embodiment.

### [Mode for Invention]

Hereinafter, embodiments disclosed in this specification will be described in detail with reference to the attached drawings. The suffixes 'module' and 'part' for components used in the following description are given or used interchangeably in consideration of ease of specification preparation, and do not have distinct meanings or roles in themselves. Additionally, the attached drawings are intended to facilitate easy understanding of the embodiments disclosed in this specification, and the technical idea disclosed in this specification is not limited by the attached drawings. Additionally, when an element such as a layer, area or substrate is referred to as being 'on' another component, this includes either directly on the other element or there may be other intermediate elements in between.

Display devices described in this specification include digital TVs, mobile phones, smart phones, laptop computers, digital broadcasting terminals, personal digital assistants (PDAs), portable multimedia players (PMPs), navigation, and slates PCs, tablet PCs, ultra-books, desktop computers, etc. However, the features according to the embodiment described in this specification may be applied to a device capable of displaying even if it is a new product type that is developed in the future.

Hereinafter, an embodiment will be described with reference to the drawings.

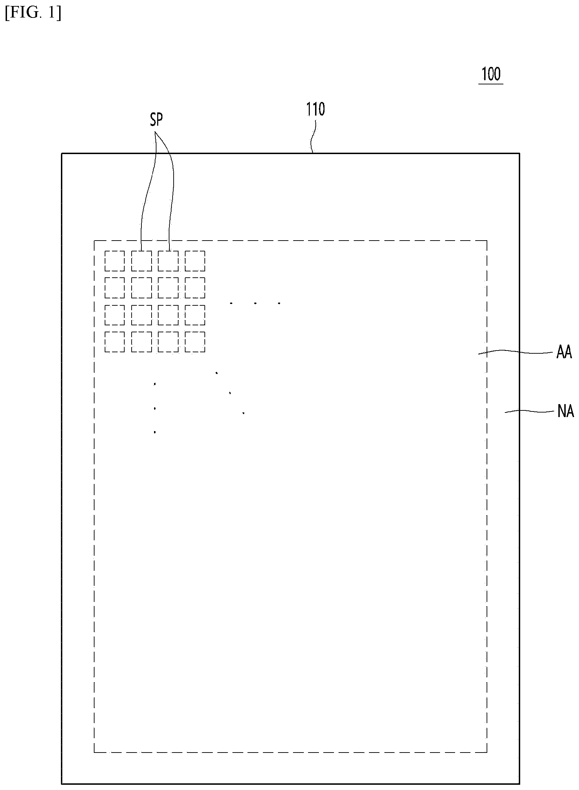

FIG. 1 is a schematic plan view of a display device according to an embodiment. For convenience of explanation, only the substrate 110 and the plurality of sub-pixels (SP) among the various components of the display device 100 are shown in FIG. 1.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the light emission of unit pixels arranged in a matrix form. A unit pixel refers to the minimum unit for implementing one color. A unit pixel of a flexible display may be implemented by a light emitting device. In the embodiment, the light emitting device may be Micro-LED or Nano-LED, but is not limited thereto.

The substrate 110 is configured to support various components included in the display device 100, and may be made of an insulating material. For example, the substrate 110 may be made of glass or resin. Additionally, the substrate 110 may include polymer or plastic, or may be made of a material with flexibility.

The substrate 110 includes a display area (AA) and a non-display area (NA).

The display area AA is an area where a plurality of sub-pixels SP are arranged and an image is displayed. Each of the plurality of sub-pixels (SP) is an individual unit that emits light, and a semiconductor light emitting device (LED) and a driving circuit are formed in each of the plurality of sub-pixels (SP). For example, the plurality of sub-pixels SP may include, but are not limited to, a red sub-pixel, a green sub-pixel, a blue sub-pixel, and/or a white sub-pixel. Hereinafter, the description will be made on the assumption that the plurality of sub-pixels SP includes a red sub-pixel, a green sub-pixel, and a blue sub-pixel, but is not limited thereto.

The non-display area (NA) is an area where images are not displayed, and is an area where various wiring, driver ICs, etc. for driving the sub-pixels (SP) arranged in the display area (AA) are placed. For example, various ICs such as gate driver ICs and data driver ICs and driving circuits may be placed in the non-display area (NA). Meanwhile, the non-display area NA may be located on the back of the substrate 110, that is, on the side without the sub-pixel SP, or may be omitted, and is not limited to what is shown in the drawing.

The display device 100 of the embodiment may drive the light emitting device including an active matrix (AM) method or a passive matrix (PM) method.

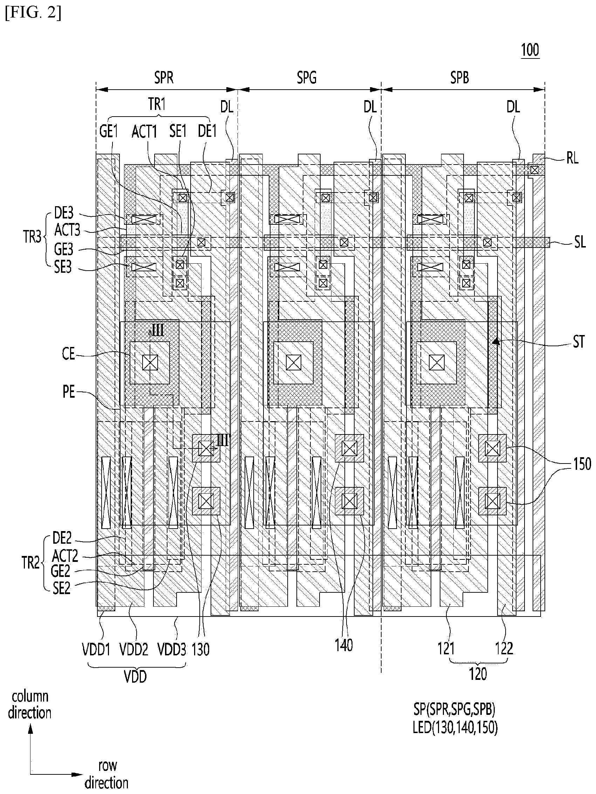

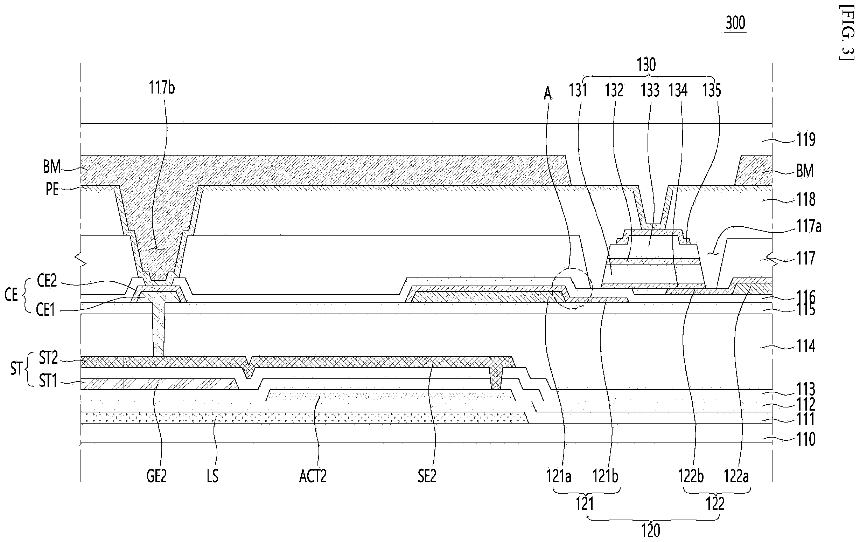

Hereinafter, FIGS. 2 and 3 will be referred to together for a more detailed description of the plurality of sub-pixels (SP).

FIG. 2 is a schematic enlarged plan view of a display device according to an embodiment. FIG. 3 is a cross-sectional view taken along line III-III' of FIG. 2. Referring to FIGS. 2 and 3, the display device 100 according to the embodiment may include a plurality of scan wires (SL), a plurality of data wires (DL), a plurality of high potential power supply wires (VDD), a plurality of assembly wirings 120, a first transistor (TR1), a second transistor (TR2), and a third transistor (TR3) of each of the plurality of reference lines (RL) and the black matrix (BM) and the plurality of sub-pixels (SP), storage capacitor (ST), semiconductor light emitting device (LED), light blocking layer (LS), a buffer layer 111, a gate insulating layer 112, a plurality of passivation layers 113, 115, 116, a plurality of planarization layers 114, 117, 118, a connection electrode (CE), a pixel electrode (PE), etc.

Referring to FIGS. 2 and 3, a plurality of data lines (DL), a first layer (VDD1) and a second layer (VDD2) of the high-potential power line (VDD), a plurality of reference wirings RL and a plurality of assembly wirings 120 extend in the column direction between the plurality of sub-pixels SP, the third layer VDD3 of the plurality of scan lines SL and the high potential power line VDD may extend in the row direction between the plurality of sub-pixels SP. Additionally, a first transistor TR1, a second transistor TR2, a third transistor TR3, and a storage capacitor ST may be disposed in each of the plurality of sub-pixels SP.

First, the first layer (VDD1) and the light blocking layer (LS) of the high-potential power supply line (VDD) may be disposed on the substrate 110.

The high-potential power supply line (VDD) is a line that transmits a high-potential power supply voltage to each of a plurality of sub-pixels (SP). A plurality of high-potential power supply lines (VDD) may transmit a high-potential power supply voltage to the second transistor TR2 of each of the plurality of sub-pixels (SP).

Meanwhile, a plurality of high-potential power wiring (VDD) may be made of a single layer or multiple layers, hereinafter, for convenience of explanation, the description will be made on the assumption that a plurality of high-potential power supply lines (VDDs) are composed of a plurality of layers.

The high-potential power line (VDD) includes a plurality of first layers (VDD1), a plurality of second layers (VDD2), and a plurality of third layers (VDD3) connecting them. The first layer VDD1 may extend in the column direction between each of the plurality of sub-pixels SP.

The light blocking layer LS may be disposed in each of the plurality of sub-pixels SP on the substrate 110. The light blocking layer LS blocks light incident from the lower part of the substrate 110 to the second active layer ACT2 of the second transistor TR2, which will be described later, and may minimize leakage current.

The buffer layer 111 may be disposed on the first layer (VDD1) and the light blocking layer (LS) of the high-potential power line (VDD). The buffer layer 111 may reduce penetration of moisture or impurities through the substrate 110. The buffer layer 111 may be composed of, for example, a single layer or a multiple layer of silicon oxide (SiOx) or silicon nitride (SiNx), but is not limited thereto. However, the buffer layer 111 may be omitted depending on the type of substrate 110 or the type of transistor, but is not limited thereto.

A plurality of scan wires (SL), a plurality of reference wires (RL), a plurality of data wires (DL), the first transistor TR1, the second transistor TR2, the third transistor TR3, and the storage capacitor ST may be disposed on the buffer layer 111.

First, the first transistor TR1 may be disposed in each of the plurality of sub-pixels SP. The first transistor TR1 may include a first active layer ACT1, a first gate electrode GE1, a first source electrode SE1, and a first drain electrode DE1. The first active layer ACT1 may be disposed on the buffer layer 111. The first active layer ACT1 may be made of a semiconductor material such as oxide semiconductor, amorphous silicon, or polysilicon, but is not limited thereto.

The gate insulating layer 112 may be disposed on the first active layer ACT1. The gate insulating layer 112 is an insulating layer for insulating the first active layer (ACT1) and the first gate electrode (GE1), and may be composed of a single layer or multiple layers of silicon oxide (SiOx) or silicon nitride (SiNx), but is not limited thereto.

The first gate electrode GE1 may be disposed on the gate insulating layer 112. The first gate electrode GE1 may be electrically connected to the scan line SL. The first gate electrode GE1 may be made of a conductive material, such as copper (Cu), aluminum (Al), molybdenum (Mo), nickel (Ni), titanium (Ti), chromium (Cr), or an alloy thereof, but is not limited to this.

The first passivation layer 113 may be disposed on the first gate electrode GE1. Contact holes are formed in the first passivation layer 113 to connect the first source electrode SE1 and the first drain electrode DE1 to the first active layer ACT1. The first passivation layer 113 is an insulating layer to protect the structure below the first passivation layer 113, and may be composed of a single layer or multiple layers of silicon oxide (SiOx) or silicon nitride (SiNx), but is not limited to this.

A first source electrode (SE1) and a first drain electrode (DE1) electrically connected to the first active layer (ACT1) may be disposed on the first passivation layer 113. The first drain electrode DE1 may be connected to the data line DL, and the first source electrode SE1 may be connected to the second gate electrode GE2 of the second transistor TR2. The first source electrode (SE1) and the first drain electrode (DE1) may be made of a conductive material, for example, copper (Cu), aluminum (Al), molybdenum (Mo), nickel (Ni), titanium (Ti), chromium (Cr), or an alloy thereof, but is not limited to this.

Meanwhile, in the embodiment, the first source electrode (SE1) and the first drain electrode (DE1) were described as being connected to the second gate electrode (GE2) and the data line (DL), respectively, depending on the type of transistor, the first source electrode SE1 may be connected to the data line DL, the first drain electrode DE1 may be connected to the second gate electrode GE2 of the second transistor TR2, but is not limited to this.

The first gate electrode GE1 of the first transistor TR1 is connected to the scan line SL, and may be turned on or off depending on the scan signal. The first transistor TR1 may transfer a data voltage to the second gate electrode GE2 of the second transistor TR2 based on the scan signal, and may be referred to as a switching transistor.

Meanwhile, a plurality of data lines DL and a plurality of reference lines RL may be disposed on the gate insulating layer 112 along with the first gate electrode GE1. The plurality of data lines DL and the reference lines RL may be formed of the same material and process as the first gate electrode GE1.

The plurality of data lines DL are lines that transmit data voltages to each of the plurality of sub-pixels SP. The plurality of data lines DL may transmit data voltage to the first transistor TR1 of each of the plurality of sub-pixels SP. For example, the plurality of data lines (DL) include a data line (DL) that transmits the data voltage to the red sub-pixel (SPR), a data line (DL) that transmits the data voltage to the green sub-pixel (SPG) and a data line DL2 that transmits a data voltage to the blue sub-pixel SPB .

The plurality of reference wires RL are wires that transmit a reference voltage to each of the plurality of sub-pixels SP. The plurality of reference lines RL may transmit a reference voltage to the third transistor TR3 of each of the plurality of sub-pixels SP.

A second transistor TR2 may be disposed in each of the plurality of sub-pixels SP. The second transistor TR2 may include a second active layer ACT2, a second gate electrode GE2, a second source electrode SE2, and a second drain electrode DE2. The second active layer (ACT2) may be disposed on the buffer layer 111. The second active layer ACT2 may be made of a semiconductor material such as oxide semiconductor, amorphous silicon, or polysilicon, but is not limited thereto.

The gate insulating layer 112 may be disposed on the second active layer ACT2, and the second gate electrode GE2 may be disposed on the gate insulating layer 112. The second gate electrode GE2 may be electrically connected to the first source electrode SE1 of the first transistor TR1. The second gate electrode GE2 is made of a conductive material, such as copper (Cu), aluminum (Al), molybdenum (Mo), nickel (Ni), titanium (Ti), chromium (Cr), or an alloy thereof, but is not limited thereto.

The first passivation layer 113 is disposed on the second gate electrode (GE2), and the second source electrode (SE2) and the second drain electrode (DE2) are disposed on the first passivation layer 113. The second source electrode SE2 is electrically connected to the second active layer ACT2. The second drain electrode DE2 is electrically connected to the second active layer ACT2 and at the same time is electrically connected to the high potential power supply line VDD. The second drain electrode DE2 may be disposed between the first layer VDD1 and the second layer VDD2 of the high potential power line VDD and electrically connected to the high potential power line VDD.

The second transistor TR2 has a second gate electrode GE2 connected to the first source electrode SE1 of the first transistor TR1, so that may be turned on by the data voltage transmitted when the first transistor TR1 is turned on. And the turned-on second transistor TR2 may transfer a driving current to the light emitting device (LED) based on the high-potential power supply voltage from the high-potential power supply line (VDD), and thus may be referred to as a driving transistor.

The third transistor TR3 may be disposed in each of the plurality of sub-pixels SP. The third transistor TR3 includes a third active layer ACT3, a third gate electrode GE3, a third source electrode SE3, and a third drain electrode DE3. The third active layer (ACT3) may be disposed on the buffer layer 111. The third active layer (ACT3) may be made of a semiconductor material such as oxide semiconductor, amorphous silicon, or polysilicon, but is not limited thereto.

The gate insulating layer 112 may be disposed on the third active layer ACT3, and the third gate electrode GE3 may be disposed on the gate insulating layer 112. The third gate electrode GE3 is connected to the scan line SL, and the third transistor TR3 may be turned on or off by the scan signal. The third gate electrode GE3 is made of a conductive material, such as copper (Cu), aluminum (Al), molybdenum (Mo), nickel (Ni), titanium (Ti), chromium (Cr), or an alloy thereof, but is not limited to this.

However, it was explained that the third gate electrode (GE3) and the first gate electrode (GE1) were connected to the same scan line (SL), but the third gate electrode GE3 may be connected to a different scan line SL from the first gate electrode GE1, but is not limited thereto.

The first passivation layer 113 is disposed on the third gate electrode GE3, and the third source electrode SE3 and the third drain electrode DE3 are disposed on the first passivation layer 113. The third source electrode (SE3) is formed integrally with the second source electrode (SE2), so that may be electrically connected to the third active layer (ACT3) and simultaneously to the second source electrode (SE2) of the second transistor (TR2). And the third drain electrode DE3 may be electrically connected to the reference wiring RL.

The third transistor (TR3) electrically connected to the second source electrode (SE2), reference wiring (RL), and storage capacitor (ST) of the second transistor (TR2), which is a driving transistor, may be referred to as a sensing transistor.

A storage capacitor (ST) may be disposed in each of the plurality of sub-pixels (SP). The storage capacitor ST may include a first capacitor electrode ST1 and a second capacitor electrode ST2. The storage capacitor ST is connected between the second gate electrode GE2 and the second source electrode SE2 of the second transistor TR2, by storing the voltage, the voltage level of the gate electrode of the second transistor TR2 may be maintained constant while the light emitting device (LED) emits light.

The first capacitor electrode ST1 may be integrated with the second gate electrode GE2 of the second transistor TR2. Accordingly, the first capacitor electrode ST1 may be electrically connected to the second gate electrode GE2 of the second transistor TR2 and the first source electrode SE1 of the first transistor TR1.

The second capacitor electrode (ST2) may be disposed on the first capacitor electrode (ST1) with the first passivation layer 113 interposed therebetween. The second capacitor electrode ST2 may be integrated with the second source electrode SE2 of the second transistor TR2 and the third source electrode SE3 of the third transistor TR3. Accordingly, the second capacitor electrode ST2 may be electrically connected to the second transistor TR2 and the third transistor TR3.

Meanwhile, the first source electrode (SE1), the first drain electrode (DE1), the second source electrode (SE2), the second drain electrode (DE2), and a plurality of scan lines SL may be disposed on the first passivation layer 113 along with the third source electrode SE3, the third drain electrode DE3, and the second capacitor electrode ST2.

The plurality of scan wires (SL) are wires that transmit scan signals to each of the plurality of sub-pixels (SP). The plurality of scan lines SL may transmit scan signals to the first transistor TR1 of each of the plurality of sub-pixels SP. For example, each of the plurality of scan lines SL extends in the row direction and may transmit a scan signal to a plurality of sub-pixels SP arranged in the same row.

Next, the first planarization layer 114 may be disposed on the plurality of scan lines (SL), a plurality of reference lines (RL), a plurality of data lines (DL), the first transistor TR1, the second transistor TR2, the third transistor TR3, and the storage capacitor (ST). The first planarization layer 114 may planarize the upper part of the substrate 110 on which the plurality of transistors are disposed. The first planarization layer 114 may be composed of a single layer or a double layer, and may be made of, for example, an acryl-based organic material, but is not limited thereto.

The second passivation layer 115 may be disposed on the first planarization layer 114. The second passivation layer 115 is an insulating layer for protecting the structure below the second passivation layer 115 and improving the adhesion of the structure formed on the second passivation layer 115, and may be composed of a single layer or multiple layers of silicon oxide (SiOx) or silicon nitride (SiNx), but is not limited thereto.

The second layer (VDD2) of the high-potential power supply wiring (VDD), the plurality of first assembly wiring lines 121 among the plurality of assembly wiring lines 120, and the connection electrode (CE) may be disposed on the second passivation layer 115.

First, the plurality of assembly wirings 120 are wires that generate an electric field to align a plurality of light emitting devices (LEDs) and supply a low-potential power supply voltage to the plurality of light emitting devices (LEDs) when the display device 100 is driven when manufacturing the display device 100. Accordingly, the assembly wiring 120 may be referred to as a low-potential power wiring. The plurality of assembly wirings 120 may be arranged in a column direction along the plurality of sub-pixels SP arranged on the same line. The plurality of assembly wirings 120 may be arranged to overlap the plurality of sub-pixels SP arranged in the same column. For example, one first assembly wiring 121 and a second assembly wiring 122 may be disposed in a red sub-pixel (SPR) arranged in the same row, one first assembly wiring 121 and one second assembly wiring 122 may be disposed in the green sub-pixel (SPG), and one first assembly wiring 121 and one second assembly wiring 122 may be disposed in the blue sub-pixel SPB.

The plurality of assembly wiring lines 120 may include a plurality of first assembly wiring lines 121 and a plurality of second assembly wiring lines 122. When the display device 100 is driven, the same low-potential voltage may be applied to the plurality of first assembly wirings 121 and the plurality of second assembly wirings 122 in alternating current. The plurality of first assembly wirings 121 and the plurality of second assembly wirings 122 may be alternately arranged. Additionally, in each of the plurality of sub-pixels SP, one first assembly wiring 121 and one second assembly wiring 122 may be disposed adjacent to each other.

The plurality of first assembly wirings 121 and the plurality of second assembly wirings 122 may be made of a conductive material, for example, copper (Cu) and chromium (Cr), but are not limited thereto.

The plurality of first assembly wirings 121 may include a first conductive layer 121a and a first clad layer 121b. The first conductive layer 121a may be disposed on the second passivation layer 115. The first clad layer 121b may be in contact with the first conductive layer 121a. For example, the first clad layer 121b may be disposed to cover the top and side surfaces of the first conductive layer 121a. And the first conductive layer 121a may have a thickness greater than that of the first clad layer 121b.

The first clad layer (121b) is made of a material that is more resistant to corrosion than the first conductive layer (121a), when manufacturing the display device 100, short circuit defects due to migration between the first conductive layer 121a of the first assembly wiring 121 and the second conductive layer 122a of the second assembly wiring 122 may be minimized. For example, the first clad layer 121b may be made of molybdenum (Mo), molybdenum titanium (MoTi), etc., but is not limited thereto.

The second layer (VDD2) of the high-potential power line (VDD) may be disposed on the second passivation layer 115. The second layer (VDD2) extends in the column direction between each of the plurality of sub-pixels (SP) and may overlap the first layer (VDD1). The first layer (VDD1) and the second layer (VDD2) may be electrically connected through a contact hole formed in the insulating layers formed between the first layer (VDD1) and the second layer (VDD2). The second layer VDD2 may be formed of the same material and process as the first assembly wiring 121, but is not limited thereto.

The connection electrode CE may be disposed in each of the plurality of sub-pixels SP. The connection electrode CE may be electrically connected to the second capacitor electrode ST2 and the second source electrode SE2 of the second transistor TR2 through a contact hole formed in the second passivation layer 115. The connection electrode (CE) is an electrode for electrically connecting the light emitting device (LED) and the second transistor (TR2), which is a driving transistor, and may include a first connection layer (CE1) and a second connection layer (CE2). For example, the first connection layer CE1 may be formed of the same material on the same layer as the first conductive layer 121a of the first assembly wiring 121, and the second connection layer CE2 may be formed of the same material as the first clad layer 121b.

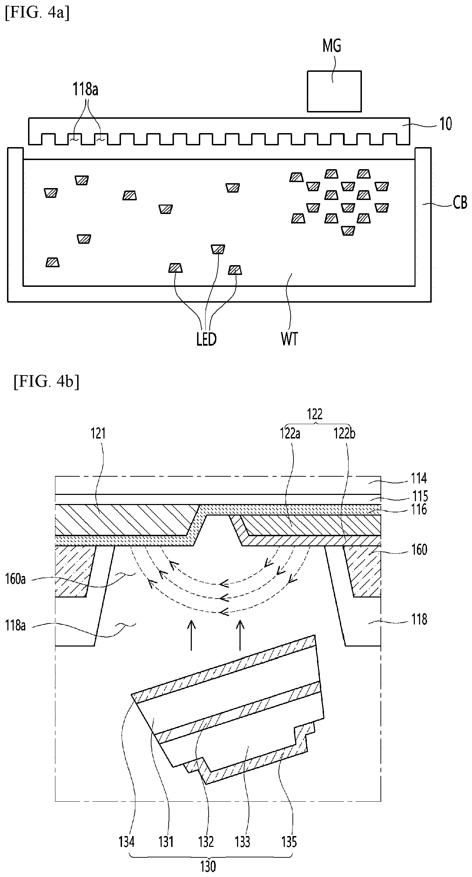

Next, the third passivation layer 116 may be disposed on the second layer (VDD2), the first assembly wiring 121, and the connection electrode (CE). The third passivation layer 116 is an insulating layer to protect the structure below the third passivation layer 116, and may be composed of a single layer or multiple layers of silicon oxide (SiOx) or silicon nitride (SiNx), but is not limited thereto. In addition, the third passivation layer 116 may function as an insulating layer to prevent short circuit defects due to migration between the first assembly wiring 121 and the second assembly wiring 122 when manufacturing the display device 100, this will be described later with reference to FIGS. 4A and 4B.

Among the plurality of assembly wiring lines 120, a plurality of second assembly wiring lines 122 may be disposed on the third passivation layer 116. Each of the plurality of second assembly wirings 122 is disposed in a plurality of sub-pixels SP arranged on the same line as described above, and the plurality of first assembly wirings 121 and the plurality of second assembly wirings 122 may be arranged to be spaced apart from each other.

Each of the plurality of second assembly wirings 122 may include a second conductive layer 122a and a second clad layer 122b. The second conductive layer 122a may be disposed on the third passivation layer 116. And the second clad layer 122b may be electrically connected to the second conductive layer 122a. For example, the second clad layer 122b may be disposed to cover the top and side surfaces of the second conductive layer 122a. And the second conductive layer 122a may have a thickness greater than that of the second clad layer 122b.

The second clad layer 122b, like the first clad layer 121b, is also made of a material that is more resistant to corrosion than the second conductive layer (122a), when manufacturing the display device 100, short-circuit defects due to migration between the first assembly wiring 121 and the second assembly wiring 122 may be minimized. For example, the second clad layer 122b may be made of molybdenum (Mo), molybdenum titanium (MoTi), etc., but is not limited thereto.

Next, the second planarization layer 117 may be disposed on the plurality of second assembly wirings 122. The second planarization layer 117 may be composed of a single layer or a double layer, and may be made of, for example, an acryl-based organic material, but is not limited thereto.

Meanwhile, the second planarization layer 117 may include a plurality of first openings 117a on which each of a plurality of light emitting devices (LEDs) is seated, and a plurality of second openings 117b exposing each of a plurality of connection electrodes (CE).

A plurality of first openings 117a may be disposed in each of the plurality of sub-pixels SP. At this time, more than one first opening 117a may be disposed in one sub-pixel SP. For example, one first opening 117a or two first openings 117a may be disposed in one sub-pixel SP.

The plurality of first openings 117a are parts into which a plurality of light emitting devices (LEDs) are inserted, and may also be referred to as pockets. The plurality of first openings 117a may be formed to overlap the plurality of assembly wirings 120. For example, one first opening 117a may overlap the first assembly wiring 121 and the second assembly wiring 122 disposed adjacent to each other in one sub-pixel SP.

Additionally, a portion of the second clad layer 122b of the plurality of second assembly wirings 122 may be exposed through the first opening 117a. On the other hand, because the third passivation layer 116 covers all of the first assembly wiring 121 in the first opening 117a, the first assembly wiring 121 overlaps the first opening 117a, but may not be exposed from the first opening 117a.

In order to form the second assembly wiring 122 in a partial area on the third passivation layer 116, it includes depositing a layer for forming the second assembly wiring 122 on the entire surface of the third passivation layer 116 and etching a portion of the second assembly wiring 122. In this case, the third passivation layer 116 may be damaged by the etchant during the process of etching the second assembly wiring 122. In particular, the insulating properties of the third passivation layer 116 are weakened in the step area (A) due to vulnerability in the step area (A), which may cause damage to the first clad layer (121b) and the first conductive layer (121a). Damage to the first clad layer 121b and the first conductive layer 121a may reduce the transfer rate of the light emitting device (LED). To solve this problem, the thickness of the third passivation layer 116 may be increased. An increase in the thickness of the third passivation layer 116 within the first opening 117a may weaken the electric field generated by the assembly wiring, thereby reducing the transfer rate of the light emitting device (LED). Therefore, structural improvement is needed to solve this problem, and the improved structure will be described in the embodiments described later.

Subsequently, a plurality of second openings 117b may be disposed in a plurality of sub-pixels SP. The plurality of second openings 117b are portions that expose the connection electrodes CE of each of the plurality of sub-pixels SP. The connection electrode CE under the second planarization layer 117 is exposed through the plurality of second openings 117b, may be electrically connected to the light emitting device (LED), and may transmit the driving current from the second transistor (TR2) to the light emitting device (LED). In this case, the third passivation layer 116 may have a contact hole in the area overlapping the second opening 117b, the connection electrode CE may be exposed from the second planarization layer 117 and the third passivation layer 116.

A plurality of light emitting devices (LEDs) may be disposed in a plurality of first openings 117a. The plurality of light emitting devices (LEDs) are light emitting devices (LEDs) that emit light by electric current. The plurality of light emitting devices (LEDs) may include light emitting devices (LEDs) that emit red light, green light, blue light, etc., and a combination of these may produce light of various colors, including white. For example, the light emitting device (LED) may be a light emitting diode (LED) or a micro LED, but is not limited thereto. In this case, micro LED means that the size of the light emitting device is 100µm or less.

### Hereinafter,

The description will be made assuming that the red light-emitting device 130 in which a plurality of light-emitting devices (LEDs) are arranged in a red sub-pixel (SPR), the green light-emitting device 140 is located in the green sub-pixel (SPG) and the blue light-emitting device 150 is located in the blue sub-pixel (SPB). However, the plurality of light emitting devices (LEDs) are composed of light emitting devices (LEDs) that emit light of the same color, images of various colors may be displayed using a separate light conversion member that converts light from a plurality of light emitting devices (LEDs) into light of different colors, but is not limited thereto.

The plurality of light-emitting devices (LEDs) include a red light-emitting device 130 disposed in a red sub-pixel (SPR), a green light-emitting device 140 disposed in the green sub-pixel (SPG) and a blue light-emitting device 150 disposed in the blue sub-pixel (SPB). Each of the red light-emitting device 130, the green light-emitting device 140, and the blue light-emitting device 150 may include a first semiconductor layer, a second semiconductor layer, a first electrode, and a second electrode in common. And the red light-emitting device 130 may include a light-emitting layer that emits red light, and the green light-emitting device 140 may include a light-emitting layer that emits green light, and the blue light emitting device 150 may include a light emitting layer that emits blue light.

Referring to FIG. 3, in the red light-emitting device 130 disposed in the red sub-pixel (SPR), the second semiconductor layer 133 may be disposed on the first semiconductor layer 131. The first semiconductor layer 131 and the second semiconductor layer 133 may be layers formed by doping n-type and p-type impurities into a specific material.

For example, the first semiconductor layer 131 and the second semiconductor layer 133 may include an AlInGaP-based semiconductor layer, for example, it may be a layer doped with a p-type or n-type impurity in a material such as indium aluminum phosphide (InAlP) or gallium arsenide (GaAs). The p-type impurities may be magnesium (Mg), zinc (Zn), beryllium (Be), etc., and the n-type impurities may be silicon (Si), germanium (Ge), tin (Sn), etc., but are not limited thereto.

The light emitting layer 132 that emits red light may be disposed between the first semiconductor layer 131 and the second semiconductor layer 133. The light emitting layer 132 may emit light by receiving holes and electrons from the first semiconductor layer 131 and the second semiconductor layer 133. The light-emitting layer 132 may have a single-layer or multi-quantum well (MQW) structure. The light-emitting layer 132 converts injected electrical energy into light with a specific wavelength within the range of about 570 nm to about 630 nm. The change in specific wavelength is determined by the size of the band gap of the light emitting diode. The band gap size may be adjusted by changing the composition ratio of Al and Ga. For example, as the composition ratio of Al increases, the wavelength becomes shorter.

The first electrode 134 may be disposed on the lower surface of the first semiconductor layer 131, and the second electrode 135 may be disposed on the upper surface of the second semiconductor layer 133. The first electrode 134 is an electrode bonded to the second assembly wiring 122 exposed through the first opening 117a, and the second electrode 135 is an electrode that electrically connects the second semiconductor layer 133 to a pixel electrode (PE), which will be described later. The first electrode 134 and the second electrode 135 may be formed of a conductive material.

In this case, in order to bond the first electrode 134 to the second assembly wiring 122, the first electrode 134 may be made of a eutectic metal. For example, the first electrode 134 is made of tin (Sn), indium (In), zinc (Zn), lead (Pb), nickel (Ni), gold (Au), platinum (Pt), and copper (Cu), but is not limited to, etc.

And both the green light-emitting device 140 and the blue light-emitting device 150 may be formed with the same or similar structure as the red light-emitting device 130. For example, the green light-emitting device 140 may include a first electrode, a first semiconductor layer on the first electrode, a green light-emitting layer on the first semiconductor layer, a second semiconductor layer on the green light-emitting layer, and a second electrode on the second semiconductor layer, and the blue light emitting device may also include a structure in which a first electrode, a first semiconductor layer, a blue light emitting layer, a second semiconductor layer, and a second electrode are sequentially stacked.

However, the green light-emitting device 140 and the blue light-emitting device 150 are formed of a compound selected from the group consisting of GaN, AlGaN, InGaN, AlInGaN, GaP, AlN, GaAs, AlGaAs, InP, and mixtures thereof, but it is not limited to this.

Meanwhile, although not shown in the drawing, an insulating layer surrounding a portion of each of the plurality of light emitting devices (LEDs) may be disposed. Specifically, the insulating layer may cover at least one side of the light emitting device (LED) among the outer surfaces of the plurality of light emitting devices (LED). An insulating layer is formed on the light emitting device (LED) to protect the light emitting device (LED), and when forming the first electrode 134 and the second electrode 135, electrical short circuit between the first semiconductor layer 131 and the second semiconductor layer 133 may be prevented.

Next, the third planarization layer 118 may be disposed on the plurality of light emitting devices (LEDs). The third planarization layer 118 may planarize the upper part of the substrate 110 on which a plurality of light emitting devices (LEDs) are disposed, a plurality of light emitting devices (LEDs) may be stably fixed in the first opening 117a by the third planarization layer 118. The third planarization layer 118 may be composed of a single layer or a double layer, and may be made of, for example, an acryl-based organic material, but is not limited thereto.

The pixel electrode (PE) may be disposed on the third planarization layer 118. The pixel electrode (PE) is an electrode for electrically connecting a plurality of light emitting devices (LED) and the connection electrode (CE). The pixel electrode (PE) may be electrically connected to the light emitting device (LED) of the first opening (117a) and the connection electrode (CE) of the second opening (117b) through a contact hole formed in the third planarization layer (118). Accordingly, the second electrode 135 of the light emitting device (LED), the connection electrode (CE), and the second transistor (TR2) may be electrically connected through the pixel electrode (PE).

The third layer (VDD3) of the high potential power line (VDD) may be disposed on the third planarization layer (118). The third layer (VDD3) may electrically connect the first layer (VDD1) and the second layer (VDD2) arranged in different rows. For example, the third layer (VDD3) extends in the row direction between the plurality of sub-pixels (SP), and may electrically connect a plurality of second layers (VDD2) of the high-potential power supply line (VDD) extending in the column direction to each other. In addition, as the plurality of high-potential power supply lines (VDD) are connected in a mesh form through the third layer (VDD3), there is a technical effect of reducing the voltage drop phenomenon.

The black matrix BM may be disposed on the third planarization layer 118. The black matrix BM may be disposed between the plurality of sub-pixels SP on the third planarization layer 118. The black matrix (BM) may prevent color mixing between the plurality of sub-pixels (SP). The black matrix (BM) may be made of an opaque material, for example, black resin, but is not limited thereto.

The protective layer 119 may be disposed on the pixel electrode (PE), the third planarization layer 118, and the black matrix (BM). The protective layer 119 is a layer to protect the structure below the protective layer 119, and may be composed of a single layer or multiple layers of translucent epoxy, silicon oxide (SiOx), or silicon nitride (SiNx), but is not limited thereto.

Meanwhile, in the first opening 117a, the plurality of first assembly wirings 121 are spaced apart from the plurality of light emitting devices (LEDs), only the plurality of second assembly wirings 122 may contact the plurality of light emitting devices (LEDs). This is during the manufacturing process of the display device 100, in order to prevent defects that occur when a plurality of light emitting devices (LEDs) come into contact with both the first plurality of assembly wirings 121 and the plurality of second assembly wirings 122, the third passivation layer 116 may be formed on the plurality of first assembly wirings 121, and the plurality of light emitting devices (LEDs) may be contacted only to the plurality of second assembly wirings 122. Hereinafter, a method of manufacturing the display device 100 according to an embodiment will be described in detail with reference to FIGS. 4A and 4B.

FIGS. 4A and 4B are process charts for explaining a manufacturing method of a display device according to an embodiment, and are process charts for explaining a process for self-assembling a plurality of light emitting devices (LEDs) into the first opening 117a.

Referring to FIG. 4A, a light emitting device (LED) is introduced into the chamber (CB) filled with the fluid (WT). The fluid WT may include water, etc., and the chamber CB filled with the fluid WT may have an open top.

Next, the mother substrate 10 may be placed on the chamber (CB) filled with light emitting devices (LEDs). The mother substrate 10 is a substrate composed of a plurality of substrates 110 forming the display device 100, when self-assembling a plurality of light emitting devices (LEDs), the mother substrate 10 on which a plurality of assembly wirings 120 and a second planarization layer 117 are formed may be used.

And the mother substrate 10 formed with the first assembly wiring 121, the second assembly wiring 122, and the second planarization layer 117 is placed on the chamber CB or inserted into the chamber CB. In this case, the mother substrate 10 may be positioned so that the first opening 117a of the second planarization layer 117 and the fluid WT face each other.

Next, the magnet MG may be placed on the mother substrate 10. Light emitting devices (LEDs) that sink or float on the bottom of the chamber (CB) may move toward the mother substrate 10 by the magnetic force of the magnet (MG).

In this case, the light emitting device (LED) may include a magnetic material to move by a magnetic field. For example, the first electrode 134 or the second electrode 135 of the light emitting device (LED) may include a ferromagnetic material such as iron, cobalt, or nickel.

Next, the light emitting device (LED) moved toward the second planarization layer 117 by the magnet (MG) may be self-assembled in the first opening 117a by the electric field formed by the first assembly wiring 121 and the second assembly wiring 122.

An alternating voltage may be applied to the plurality of first assembly wirings 121 and the plurality of second assembly wirings 122 to generate an electric field. Due to this electric field, the light emitting device (LED) is dielectrically polarized and may have polarity. And a dielectric polarized light emitting device (LED) may be moved or fixed in a specific direction by dielectrophoresis (DEP), that is, an electric field. Therefore, a plurality of light emitting devices (LEDs) may be fixed within the first opening 117a of the second planarization layer 117 using dielectrophoresis.

Next, in a state in which the light emitting device (LED) is fixed in the first opening 117a using the electric field of the plurality of first assembly wirings 121 and the plurality of second assembly wirings 122, the motherboard substrate 10 may be flipped 180°. In the embodiment, the mother substrate 10 may be turned over while voltage is applied to the plurality of first assembly wirings 121 and the plurality of second assembly wirings 122 and a subsequent process may be performed.

And with the first electrode 134 of the light emitting device (LED) located on the second assembly wiring 122, the light emitting device (LED) may be bonded to the second assembly wiring 122 by applying heat and pressure to the light emitting device (LED). For example, the first electrode 134 of the light emitting device (LED) may be bonded to the second assembly wiring 122 through eutectic bonding. Eutectic bonding is a bonding method using heat compression at high temperatures and is one of the bonding processes that is very strong and highly reliable. The eutectic bonding method not only realizes high bonding strength, but also has the advantage of eliminating the need to apply a separate adhesive from the outside. However, the bonding method of the plurality of light emitting devices (LEDs) may be configured in various ways other than eutectic bonding, but is not limited thereto.

Meanwhile, different voltages are applied to the plurality of first assembly wirings 121 and the plurality of second assembly wirings 122 when manufacturing the display device 100, but the same voltage may be applied when the display device 100 is driven. To this end, when manufacturing the display device 100, the plurality of first assembly wirings 121 and the plurality of second assembly wirings 122 may be connected to different assembly pads and different voltages may be applied.

Therefore, after placing the mother substrate 10 in the chamber (CB) into which a plurality of light emitting devices (LEDs) are inserted, an electric field may be formed by applying an alternating voltage to a plurality of assembly wirings 120 through a plurality of assembly pads, and a plurality of light emitting devices (LEDs) may be easily self-assembled into the first opening 117a of the second planarization layer 117.

On the other hand, when self-assembling a plurality of light-emitting devices (LEDs) for each sub-pixel (SP), a plurality of assembly wirings 120 arranged in a plurality of red sub-pixels (SPR), a plurality of assembly wirings 120 arranged in a plurality of green sub-pixels (SPG), and a plurality of assembly wirings 120 arranged in a plurality of blue sub-pixels (SPB) may be connected to different assembly pads. The light emitting device (LED) may be selectively self-assembled only in a specific sub-pixel (SP) among the plurality of sub-pixels (SP) through a plurality of assembly pads. The self-assembled mother substrate 10 may be separated into a plurality of substrates 110 by scribing. Thereafter, through a link wire connecting the plurality of first assembly wirings 121 into one and a link wire connecting the plurality of second assembly wirings 122 into one, the same voltage may be easily applied to the plurality of first assembly wirings 121 and the plurality of second assembly wirings 122.

In the display device 100 according to the embodiment, at least some of the plurality of assembly wirings 120 for self-assembly of the plurality of light emitting devices (LEDs) may be used as wiring for applying a low-potential power supply voltage to the plurality of light emitting devices (LEDs). When manufacturing the display device 100, a plurality of light emitting devices (LEDs) floating in the fluid WT may be moved adjacent to the mother substrate 10 using a magnetic field. Subsequently, different voltages may be applied to the plurality of first assembly wirings 121 and the plurality of second assembly wirings 122 to form an electric field, a plurality of light emitting devices (LEDs) may be self-assembled within the plurality of first openings 117a by an electric field. In this case, instead of separately forming a wiring supplying a low-potential voltage and connecting it to a plurality of self-assembled light emitting devices (LEDs), by bonding the first electrode 134 of the light emitting device (LED) to the second assembly wiring 122, a portion of which is exposed within the first opening 117a, when driving the display device 100, a plurality of assembly wirings 120 may be used as wiring for supplying low-potential voltage to a plurality of light emitting devices (LEDs). Accordingly, in the display device 100 according to the embodiment, the plurality of assembly wirings 120 may be used not only for self-assembly of the plurality of light emitting devices (LED) but also as wiring for driving the plurality of light emitting devices (LED).

In the display device 100 according to the embodiment, the plurality of assembly wiring 120 includes a clad layer, so that corrosion of the plurality of assembly wiring 120 or short circuit defects may be reduced. The plurality of first assembly wirings 121 are composed of a first conductive layer 121a and a first clad layer 121b that surrounds the first conductive layer 121a and is more resistant to corrosion than the first conductive layer 121a, the plurality of second assembly wirings 122 includes a second conductive layer 122a and a second clad layer 122b that surrounds the second conductive layer 122a and is more resistant to corrosion than the second conductive layer 122a. When manufacturing the display device 100, the mother substrate 10 on which the plurality of assembly wirings 120 are formed is placed in the fluid WT to self-assemble the plurality of light emitting devices (LEDs). In this case, the first conductive layer 121a and/or the second conductive layer 122a may be exposed in the fluid WT and the assembly wiring 120 may be corroded, which may cause a short circuit defect. Therefore, the first conductive layer 121a of the plurality of first assembly wirings 121 may be covered with the second passivation layer 115 and the first clad layer 121b, the second conductive layer 122a of the plurality of second assembly wirings 122 may be covered with the third passivation layer 116 and the second clad layer 122b. Accordingly, the plurality of assembly wiring lines 120 are formed in a structure including the first clad layer 121b and the second clad layer 122b, thereby improving the reliability of the plurality of assembly wiring lines 120.

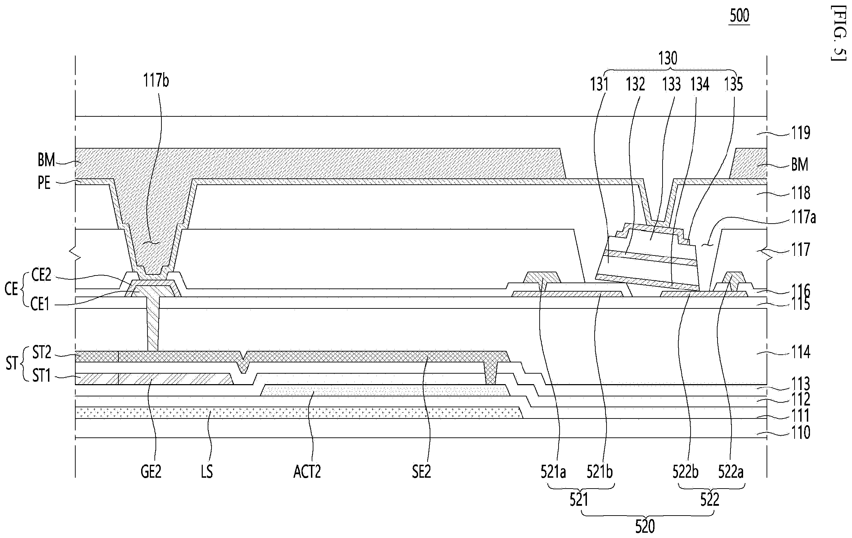

Next, FIG. 5 is a cross-sectional view of the display device according to the second embodiment. The second embodiment of FIG. 5 may adopt the features of the first embodiment, and the description will focus on the modified form of the assembly wiring.

Referring to FIG. 5, the first conductive layer 521a of the first assembly wiring 521 and the second conductive layer 522a of the second assembly wiring 522 overlap the second planarization layer 117. The second planarization layer 117 may cover both the first conductive layer 521a of the first assembly wiring 521 and the first conductive layer 522a of the second assembly wiring 522, and the first conductive layer 521a and the second conductive layer 522a may be spaced apart from the first opening 117a.

The first clad layer 521b of the first assembly wiring 521 is disposed between the first conductive layer 521a and the second passivation layer 115. And instead of the first conductive layer 521a that does not overlap the first opening 117a, and the first clad layer 521b extends toward the first opening 117a to form an electric field for self-assembly of the light emitting device (LED). The first conductive layer 521a contacts the first clad layer 521b through the contact hole of the third passivation layer 116.

A portion of the first clad layer 521b overlaps the second planarization layer 117 and the first conductive layer 521a, the remaining portion of the first clad layer 521b may extend inside the first opening 117a and overlap the light emitting device (LED). However, since the third passivation layer 116 is disposed on the first clad layer 521b, the first clad layer 521b does not contact the first electrode 134 of the light emitting device (LED).

The second clad layer 522b of the plurality of second assembly wirings 522 is disposed between the second conductive layer 522a and the second passivation layer 115. And instead of the second conductive layer 522a that does not overlap the first opening 117a, the second clad layer 522b extends toward the first opening 117a, an electric field for self-assembly of a light emitting device (LED) may be formed together with the first clad layer 521b.

A portion of the second clad layer 522b overlaps the second planarization layer 117 and the first conductive layer 522b, the remaining portion of the second clad layer 522b may extend inside the first opening 117a and overlap the light emitting device (LED). In this case, since the second clad layer 522b is disposed on the second passivation layer 115, the second clad layer 522b and the first electrode 134 of the plurality of light-emitting devices (LEDs) may be in contact with each other, and a low-potential power supply voltage from the second assembly wiring 522 may be supplied to the light-emitting devices (LEDs).

As mentioned above, during the patterning process of the second conductive layer 522a and the second clad layer 522b, to prevent damage to the first assembly wiring 521 by the etchant, the thickness of the third passivation layer 116 may be increased. But the third passivation layer 116 with an increased thickness may reduce the assembly rate of the light emitting device (LED).

Referring to FIG. 3, damage to the first assembly wiring 121 caused by the etchant is caused by the fact that the first conductive layer 121a, which is relatively thick compared to the thickness of the first clad layer 121b, is disposed under the first clad layer 121b, a step area A may occur and the thickness may decrease when forming the third passivation layer 116 in the step area A.

Therefore, by disposing the first clad layer 521b below the first conductive layer 521a as in the embodiment of FIG. 5, there is a technical effect of preventing the occurrence of steps due to the thickness of the first conductive layer 521a and maintaining a constant thickness of the third passivation layer 116. In addition, there is a technical effect of simplifying the process by simultaneously forming the first clad layer 521b and the second clad layer 522b on the second passivation layer 115.

In the display device 500 according to the second embodiment, the first clad layer 521b of the first assembly wiring 521 and the second clad layer 522b of the second assembly wiring 522 may be disposed below the first conductive layer 521b of the first assembly wiring 521 and the second conductive layer 522a of the second assembly wiring 522. Therefore, the occurrence of steps due to the first conductive layer 521a and the second conductive layer 522a may be prevented and the thickness of the third passivation layer 116 may be kept constant, so that there is a technical effect of preventing damage to the assembly wiring 520 due to the etchant and facilitating self-assembly of the light emitting device through a plurality of assembly wirings.

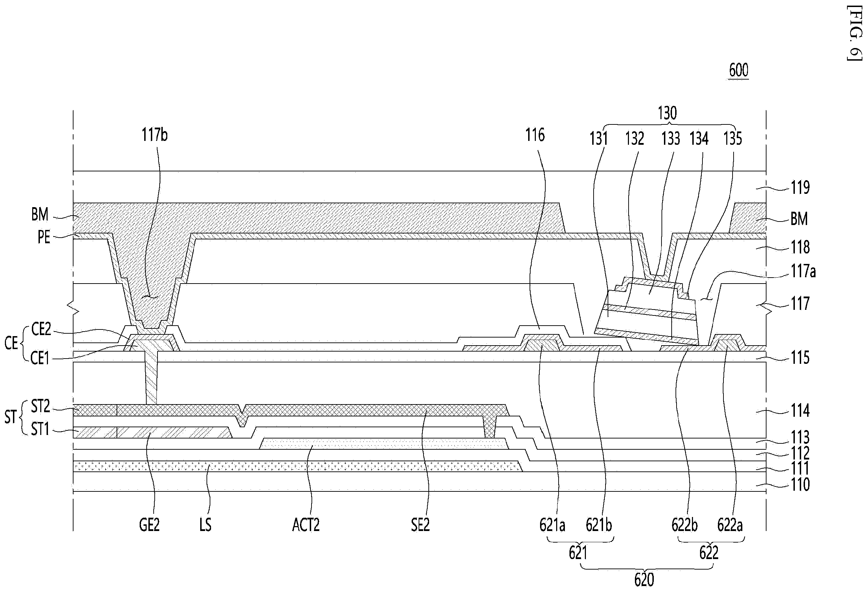

FIG. 6 is a cross-sectional view of a display device according to a third embodiment. The third embodiment of FIG. 6 may adopt the features of the second embodiment.

Referring to FIG. 6, the first assembly wiring 621 and the second assembly wiring 622 may be disposed on the second passivation layer 115. The first conductive layer 621a of the first assembly wiring 621 and the second conductive layer 622a of the second assembly wiring 622 may be disposed on the second passivation layer 115. The first conductive layer 621a and the second conductive layer 622a may be formed on the same layer with the same material through the same process, but are not limited thereto.

The first conductive layer 621a may overlap the second planarization layer 117 disposed on the first conductive layer 621a and may not overlap the first opening 117a. Likewise, the second conductive layer 622a may overlap the second planarization layer 177 disposed on the second conductive layer 622a and may not overlap the first opening 117a. That is, the second planarization layer 177 may cover each of the first conductive layer 621a and the second conductive layer 622a.

The first clad layer 621b of the first assembly wiring 621 covers the first conductive layer 621a on the first conductive layer 621a, a portion of the first clad layer 621b may overlap the second planarization layer 117. The remaining portion of the first clad layer 621b may extend inside the first opening 117a and overlap the light emitting device (LED). Likewise, the second clad layer 622b of the second assembly wiring 622 covers the second conductive layer 622a on the second conductive layer 622a, a portion of the second clad layer 622b may overlap the second planarization layer 117. The remaining portion of the second clad layer 622b may extend inside the first opening 117a and overlap the light emitting device (LED).

The third passivation layer 116 covering the first assembly wiring 621 may be disposed on the first assembly wiring 621. The third passivation layer 116 electrically insulates the first assembly wiring 621 from the light emitting device (LED) to prevent short circuit. The third passivation layer 116 may cover the remaining area excluding the second assembly wiring 622. That is, the first electrodes 134 of the plurality of light emitting devices (LEDs) may be electrically connected only to the second clad layer 622b.

Referring to FIG. 3, the first assembly wiring 121 and the second assembly wiring 122 using an etchant may be disposed on different layers with the third passivation layer 116 interposed therebetween. Accordingly, when forming the second assembly wiring 121, the thickness of the third passivation layer 116 may decrease in the step area A due to an etchant, etc., thereby reducing the insulating properties.

Therefore, by arranging the first assembly wiring 621 and the second assembly wiring 622 on the same layer as in the third embodiment of FIG. 6, so that there is a technical effect of maintaining the assembly performance of the light emitting device (LED) by preventing damage to the third passivation layer 116 covering the first assembly wiring 621. In addition, the first clad layer 621b covers the first conductive layer 621a and the second clad layer 622b covers the second conductive layer 622a, so that there is a technical effect of preventing corrosion of the first conductive layer 621a and the second conductive layer 622a.

In the display device 600 according to the third embodiment, the first clad layer 621b of the first assembly wiring 621 and the second clad layer 622b of the second assembly wiring 622 cover the first conductive layer 621b of the first assembly wiring 621 and the second conductive layer 622a of the second assembly wiring 622, and the first assembly wiring 621 and the second assembly wiring 622 may be disposed on the same layer. Therefore, it is possible to prevent corrosion of the first conductive layer 621a and the second conductive layer 622a and damage to the third passivation layer 116, there is a technical effect that may facilitate self-assembly of light-emitting devices through assembly wiring.

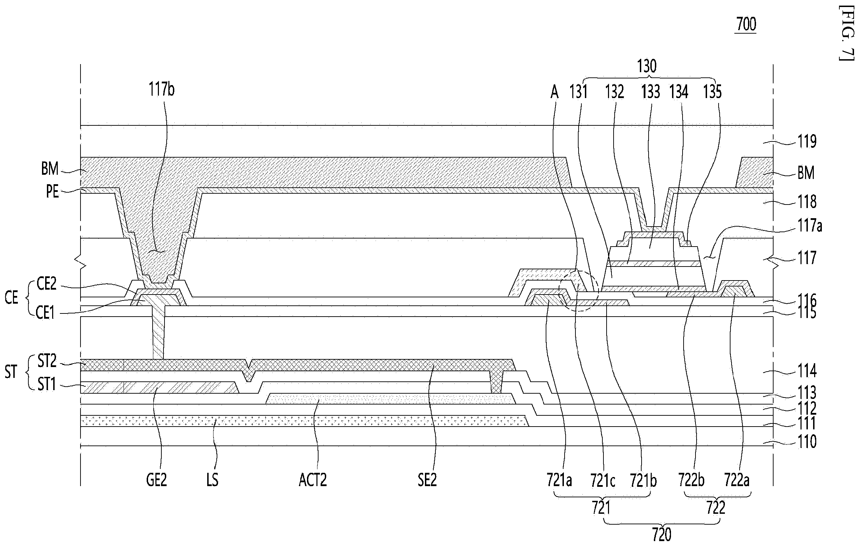

FIG. 7 is a cross-sectional view of a display device according to the fourth embodiment. The fourth embodiment of FIG. 7 may adopt the features of the second and third embodiments.

Referring to FIG. 7, the first conductive layer 721a of the first assembly wiring 721 is disposed on the second passivation layer 115, the first clad layer 721b is disposed to cover the first conductive layer 721a. The first clad layer 721b covers the top and side surfaces of the first conductive layer 721a, and extends inside the first opening 117a of the second planarization layer 117 to overlap the light emitting device (LED).

A portion of the first clad layer 721b is in contact with the upper surface of the first conductive layer 721a and may overlap the second planarization layer 117. The remaining portion of the first clad layer 721b may extend inside the first opening 117a and overlap the light emitting device (LED).

The third passivation layer 116 covers the first assembly wiring 721, and the second assembly wiring 722 is disposed on the third passivation layer 116. The second conductive layer 722a of the second assembly wiring 722 is disposed on the third passivation layer 116, the second clad layer 722b covers the top and side surfaces of the second conductive layer 722a, and extends inside the first opening 117a of the second planarization layer 117 to overlap the light emitting device (LED).

A portion of the second clad layer 722b may overlap the second conductive layer 722a and the second planarization layer 117 at the same time. The remaining portion of the second clad layer 722b may extend inside the first opening 117a and be electrically connected to the light emitting device (LED).

As previously explained, the third passivation layer 116 may be damaged by the etchant when forming the second assembly wiring 722, to prevent this, a step protection layer 721c may be disposed to cover the step area A of the first assembly wiring 721.

The step protective layer 721c covers the step area A and may overlap a portion of the first conductive layer 721a, a portion of the first clad layer 721b, and the second planarization layer 117. The step protective layer 721c is covered by the second planarization layer 117 and may not be exposed to the first opening 117a.

The step protective layer 721c may be disposed on the third passivation layer 116 together with the second conductive layer 722a and may be formed of the same material. The step protective layer 721c and the third conductive layer 722a may be formed through the same process, but are not limited thereto.

Therefore, when the first assembly wiring 721 and the second assembly wiring 722 are placed on different layers to form the second assembly wiring 722, although the first assembly wiring 721 may be affected by the etchant used, by disposing the step protective layer 721c to cover the step area A of the first assembly wiring 721, there is a technical effect of maintaining the assembly performance of the light emitting device (LED) by preventing damage to the third passivation layer 116.

In the display device 700 according to the fourth embodiment, when the first assembly wiring 721 is disposed on the lower part of the third passivation layer 116 and the second assembly wiring 722 is disposed on the upper part of the third passivation layer 116, a step protection layer 721c may be disposed to cover the step area A of the first assembly wiring 721. Accordingly, corrosion of the first assembly wiring 721 and damage to the third passivation layer 116 may be prevented, which has the technical effect of facilitating self-assembly of the light emitting device through the assembly wiring.

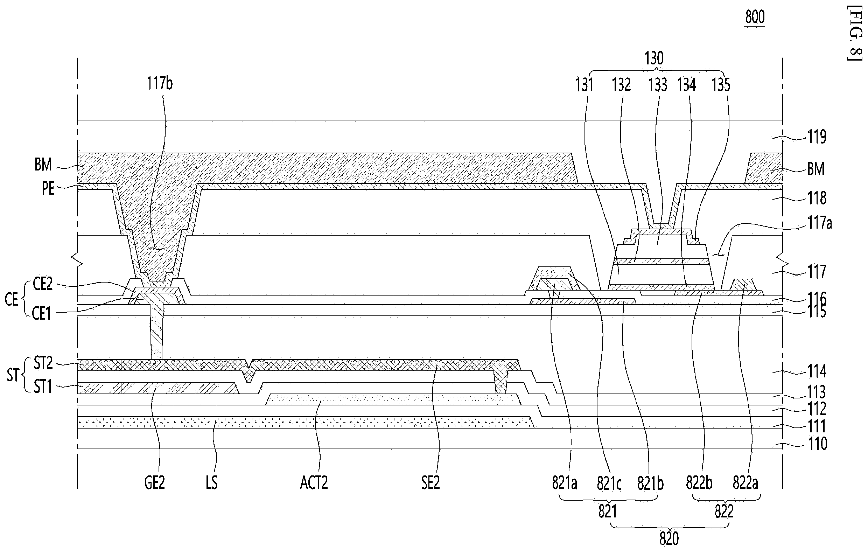

FIG. 8 is a cross-sectional view of a display device according to the fifth embodiment. The fifth embodiment of FIG. 8 may adopt the features of the second to fourth embodiments.

Referring to FIG. 8, the first conductive layer 821a of the first assembly wiring 821 and the second conductive layer 822a of the second assembly wiring 822 overlap the second planarization layer 117. The second planarization layer 117 may cover both the first conductive layer 821a of the first assembly wiring 821 and the first conductive layer 822a of the second assembly wiring 822, the first conductive layer 821a and the second conductive layer 822a may be spaced apart from the first opening 117a.

The first clad layer 821b of the first assembly wiring 821 may be disposed between the first conductive layer 821a and the second passivation layer 115. And instead of the first conductive layer 821a that does not overlap the first opening 117a, the first clad layer 821b extends toward the first opening 117a, it is possible to form an electric field for self-assembly of a light emitting device (LED). The first conductive layer 821a may be in contact with the first clad layer 821b through the contact hole of the third passivation layer 116.

The first clad layer 821b is disposed on the second passivation layer 115, a portion of the first clad layer 821b overlaps the second planarization layer 117 and the first conductive layer 821a, the remaining portion of the first clad layer 821b may extend inside the first opening 117a and overlap the light emitting device LED. However, since the third passivation layer 116 is disposed on the first clad layer 821b, the first clad layer 821b may not be in contact with the first electrode 134 of the light emitting device (LED).

The second clad layer 822b of the plurality of second assembly wirings 822 may be disposed between the second conductive layer 822a and the third passivation layer 116. And instead of the second conductive layer 822a that does not overlap the first opening 117a, the second clad layer 822b extends toward the first opening 117a, an electric field for self-assembly of a light emitting device (LED) may be formed together with the first clad layer 821b.

The second clad layer 822b is disposed on the third passivation layer 116, a portion of the second clad layer 822b overlaps the second planarization layer 117 and the second conductive layer 822b, the remaining portion of the second clad layer 822b may extend inside the first opening 117a and overlap the light emitting device LED. In this case, since the second clad layer 822b is disposed on the third passivation layer 116, the second clad layer 822b and the first electrode 134 of the light emitting device (LED) may be in contact with each other, and a low-potential power supply voltage from the second assembly wiring 822 may be supplied to the light emitting device (LED).

The second clad layer 822b may be disposed on the same layer and made of the same material as the first conductive layer 821a. The second clad layer 822b may be formed through the same process as the first conductive layer 821a, but is not limited thereto.

In order to prevent damage to the first assembly wiring 821 by the etchant during the patterning process of the second conductive layer 822a and the second clad layer 822b, by disposing the first clad layer 821b below the first conductive layer 821a, the generation of step areas may be prevented. However, when the first assembly wiring 821 and the second assembly wiring 822 are not arranged on the same layer as in the embodiment of FIG. 8, since the first conductive layer 821a is exposed when forming the second assembly wiring 822, the first conductive layer 821a may be damaged. Accordingly, the third conductive layer 821c covering the first conductive layer 821a may be disposed on the first conductive layer 821a.

The third conductive layer 821c covers the top and side surfaces of the first conductive layer 821a, and may be disposed on the same layer and made of the same material as the second conductive layer 822a. The third conductive layer 821c may be formed through the same process as the second conductive layer 822a, but is not limited thereto.

In the display device 800 according to the fifth embodiment, when the first assembly wiring 821 and the second assembly wiring 822 are arranged on different layers, and the first clad layer 821b of the first assembly wiring 821 and the second clad layer 822b of the second assembly wiring 822 are disposed below the first conductive layer 821b of the first assembly wiring 821 and the second conductive layer 822a of the second assembly wiring 822, the third conductive layer 821c may be disposed on the first conductive layer 821a to cover the first conductive layer 821a. Accordingly, there is a technical effect of preventing damage to the first assembly wiring 821 due to the etchant of the second assembly wiring 822 and facilitating self-assembly of the light emitting device through a plurality of assembly wirings.

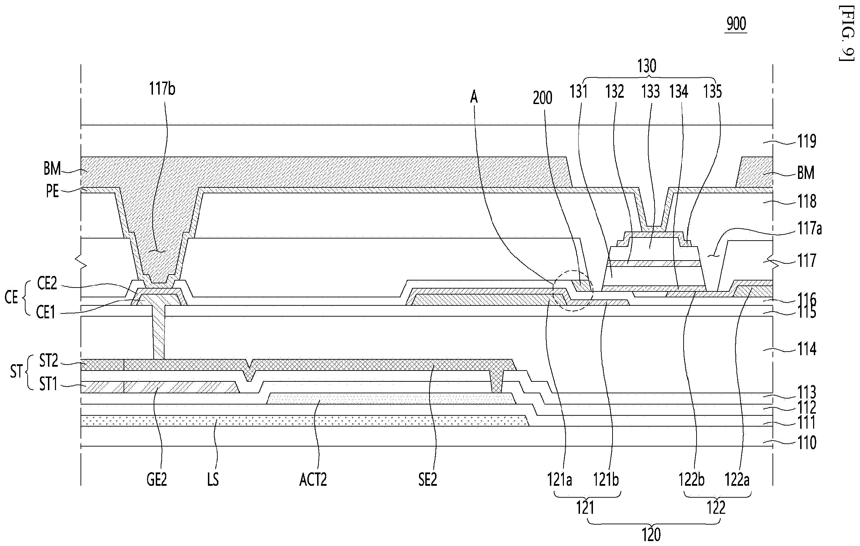

Next, FIG. 9 is a cross-sectional view of the display device 900 according to the sixth embodiment. The sixth embodiment may adopt the features of the first embodiment.

Referring to FIG. 9, the first conductive layer 121a may be disposed on the second passivation layer 115. Additionally, the first clad layer 121b may be arranged to cover both the top and side surfaces of the first conductive layer 121a. Additionally, the first clad layer 121b of the first assembly wiring 121 may extend inside the first opening 117a toward the second assembly wiring 122. At this time, there may be a height difference between the first clad layer 121b disposed on the upper surface of the first conductive layer 121a and the first clad layer 121b disposed inside the first opening 117a. A step may be formed in the first assembly wiring due to the height difference.

Along the step formed in the first assembly wiring 121, a step may also be formed in the third passivation layer 116 disposed on the first assembly wiring 121. According to the sixth embodiment, the first insulating layer 200 may be disposed in the step area of the third passivation layer 116.

As the first insulating layer 200 fills the step area A of the third passivation layer 116, there is a technical effect of protecting the assembly wiring electrodes, which may become vulnerable during external shock or self-assembly, in the step area A.

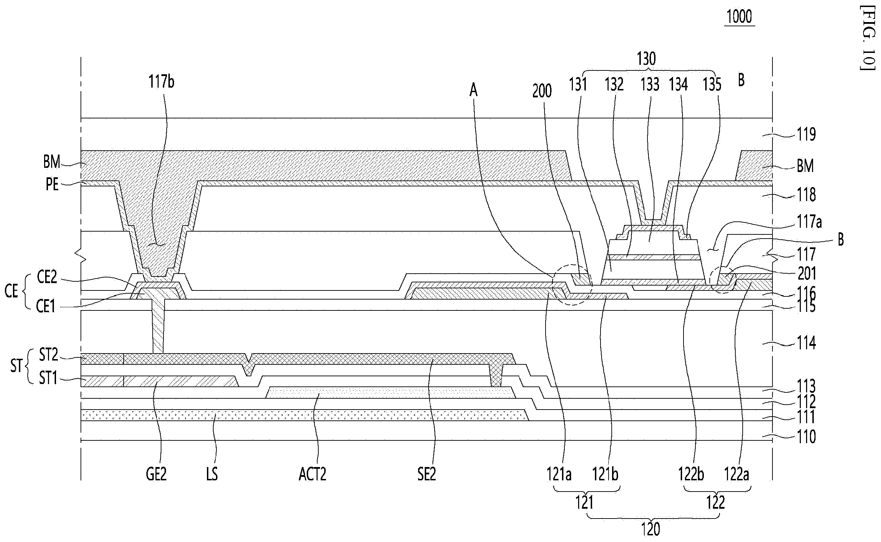

Next, FIG. 10 is a cross-sectional view of the display device 1000 according to the seventh embodiment. The seventh embodiment may adopt the features of the first and sixth embodiments.

For example, the sixth embodiment has the feature of protecting the wiring electrode by disposing an insulating layer in the step area of the passivation layer.

The following description will focus on the main features of the seventh embodiment. Referring to FIG. 10, in the second assembly wiring 122, the second conductive layer 122a may be disposed on the third passivation layer 116. The second clad layer 122b may be disposed to cover the top and side surfaces of the second conductive layer 122a. And the second clad layer 122b of the second assembly wiring 122 may extend inside the first opening 117a toward the first assembly wiring 121.

At this time, there may be a height difference between the second clad layer 122b disposed on the second conductive layer and the second clad layer 122b disposed inside the first opening 117a. A step may be formed in the second assembly wiring 122 due to the height difference.

According to the seventh embodiment, the second insulating layer 201 may be disposed in the step area B of the second assembly wiring. As the second insulating layer 201 fills the step area B of the second assembly wiring 122, there is a technical effect of protecting the assembly wiring electrodes, which may become vulnerable during external shock or self-assembly, in the step area (B).

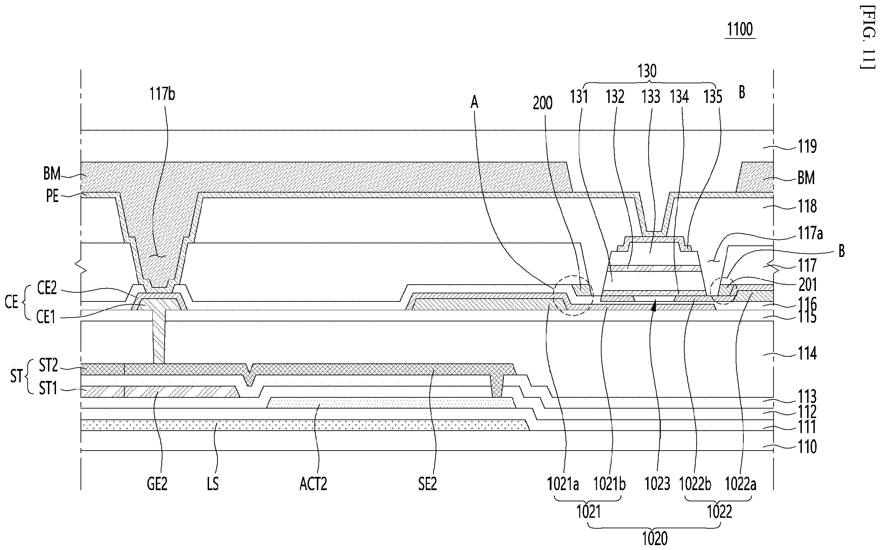

Next, FIG. 11 is a cross-sectional view of the display device 1100 according to the eighth embodiment. The seventh embodiment may adopt the features of the seventh embodiment.

For example, the seventh embodiment has the technical effect of protecting the wiring electrode by placing an insulating layer in the step area of the assembly wiring.

The following description will focus on the main features of the eighth embodiment.

Referring to FIG. 11, the first clad layer 1021b of the first assembly wiring 1021 may extend from the first conductive layer 1021a toward the second assembly wiring 1022. Additionally, the second clad layer 1022b of the second assembly wiring may extend from the second conductive layer 1022a toward the first assembly wiring 1021.

In the seventh embodiment, the first clad layer 1021b and the second clad layer 1022b are disposed with the third passivation layer 116 therebetween, so that they may overlap top and bottom.

Meanwhile, the second clad layer 1022b may be provided with a predetermined electrode hole 1023 in an area overlapping with the light emitting device 130 and the first clad layer 1021b. The width of the electrode hole 1023 may be smaller than the width of the light emitting device 130.

Additionally, an alternating current voltage may be applied to the first clad layer 1021b and the second clad layer 1022b to form an electric field.

The DEP force caused by this electric field may be concentrated in the electrode hole 1023 provided in the second clad layer (1022b).

The light emitting device 130 may be self-assembled within the first opening 117a by concentrated dielectrophoretic force (DEP force).

There is a technical effect of strengthening the assembly force for the light emitting device 130 due to the vertical overlap of the assembly wirings 1021 and 1022. In addition, the first opening 117a does not vertically overlap the first conductive layer 1021a and the second conductive layer 1022a, which has the technical effect of reducing the thickness of the panel.

Meanwhile, the second clad layer 1022b may be disposed below the light emitting device (LED). Additionally, the second clad layer 1022b may be in contact with the first electrode 134 of the light emitting device (LED).

Therefore, as the second clad layer 1022b is disposed on the lower surface of the first electrode 134 of the light emitting device (LED), the light emitting devices 130 are supported uniformly and have a wide electrical contact area between the light emitting devices 130, thereby improving carrier injection efficiency, resulting in a complex technical effect of improving luminous efficiency and brightness.

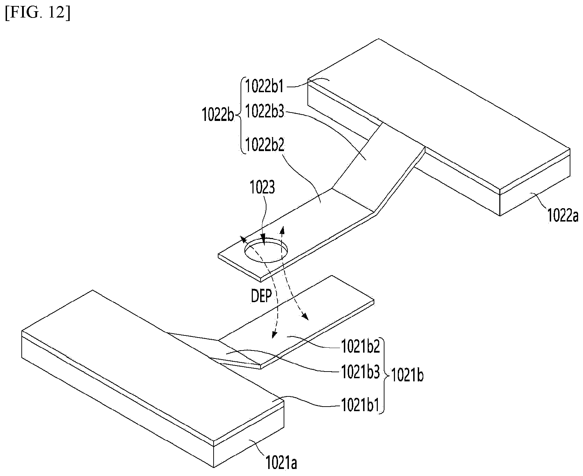

Next, FIG. 12 is a detailed diagram showing the assembly wiring 1020 in the display device 1000 of the eighth embodiment.

Referring to FIG. 12, in the eighth embodiment, a portion of the first clad layer 1021b and a portion of the second clad layer 1022b may overlap top and bottom. For example, the first clad layer 1021b may include a first-first clad layer 1021b1, a first-second clad layer 1021b2, and a first-third clad layer 1021b3. The first-second clad layer 1021b2 may be a protruding electrode extending from the first-first clad layer 1021b1 toward the second clad layer 1022b.

Additionally, the second clad layer 1022b may include a second-first clad layer 1022b1, a second-second clad layer 1022b2, and a second-third clad layer 1022b3. The second-second clad layer 1022b2 may be a protruding electrode extending from the second-first clad layer 1022b1 toward the first clad layer 1021b.

At this time, the first-second clad layer 1021b2 and the second-second clad layer 1022b2 may overlap vertically.

Additionally, the second-second clad layer 1022b2 may include an electrode hole 1023. Accordingly, DEP force may be concentrated and formed in the electrode hole 1023 of the second clad layer 1022b, and the Dep force is uniformly distributed in the assembly hole 1023, resulting in a technical effect of improving assembly force.

Additionally, the second-third clad layer 1022b3 connecting the second-second clad layer 1022b1 and the second-second clad layer 1022b2 may be arranged to have an inclined surface. Through this, the second conductive layer 1022a is disposed in an area other than the first opening 117a, which has the technical effect of reducing the thickness of the panel.

In the display device including the semiconductor light-emitting device according to the above-described embodiment, by placing the cladding layer of the assembly wiring under the conductive layer, it is possible to prevent the occurrence of steps due to the thickness of the conductive layer, and the thickness of the passivation layer arranged to cover the clad layer may also be maintained constant, which has the technical effect of facilitating self-assembly of light-emitting devices through assembly wiring.

In addition, in the embodiment, when the first assembly wiring and the second assembly wiring are arranged in different layers, a step protective layer is disposed on the assembly wiring arranged below, there is a technical effect in reducing corrosion of assembly wiring and self-assembly defects.

In addition, the embodiment has the technical effect of preventing corrosion of the conductive layer by using a clad layer that is resistant to corrosion.

In addition, the embodiment has the technical effect of protecting the assembly wiring by placing an insulating layer in the step area when a step occurs in the assembly wiring.

In addition, the embodiment has the technical effect of improving the assembly force of the light emitting device by arranging the first assembly wiring and the second assembly wiring to overlap vertically.

The above detailed description should not be construed as restrictive in any respect and should be considered illustrative. The scope of the embodiments should be determined by reasonable interpretation of the appended claims, and all changes within the equivalent scope of the embodiments are included in the scope of the embodiments.

### [Explanation of cited references]

10: Motherboard AA: Display area NA: Non-display area SP: Sub-pixel
SPR: Red sub-pixel SPG: Green sub-pixel SPB: Blue sub-pixel
100, 300, 500, 600, 700, 800, 900, 1000: Display devices
110: Substrate 111: Buffer layer 112: Gate insulating layer 113: First passivation layer
114: first planarization layer 115: second passivation layer 116: third passivation layer
117: second planarization layer 117a: first opening 117b: second opening 118: third planarization layer
119: protective layer 120, 520, 620, 720, 820, 1020: assembly wiring
121, 521, 621, 721, 821, 1021: first assembly wiring
121a, 521a, 621a, 721a, 821a, 1021a: first conductive layer
121b, 521b, 621b, 721b, 821b, 1021b: first clad layer
122, 522, 622, 722, 822, 1022: second assembly wiring
122a, 522a, 622a, 722a, 822a, 1022a: second conductive layer
122b, 522b, 622b, 722b, 822b, 1022b: second clad layer
1021b1: first-first clad layer 1021b2: first-second clad layer 1021b3: first-third clad layer
1022b1: second-first clad layer 1022b2: second-second clad layer 1022b3: second-third clad layer
1023: Electrode hole 200: First insulating layer 201: Second insulating layer 721c: Step protective layer
821c: Third conductive layer LED: Light-emitting device 130: Red light-emitting device
131: first semiconductor layer 132: light emitting layer 133: second semiconductor layer 134: first electrode
135: Second electrode 140: Green light emitting device 150: Blue light emitting device LS: Light blocking layer
SL: Scan wire DL: Data wire RL: Reference wire VDD: High potential power wire
VDD1: first layer VDD2: second layer VDD3: third layer TR1: first transistor
ACT1: first active layer GE1: first gate electrode SE1: first source electrode
DE1: first drain electrode TR2: second transistor ACT2: second active layer
GE2: second gate electrode SE2: second source electrode DE2: second drain electrode
TR3: Third transistor ACT3: Third active layer GE3: Third gate electrode
SE3: Third source electrode DE3: Third drain electrode SA, B: Step area
ST: Storage capacitor ST1: First capacitor electrode ST2: Second capacitor electrode
CE: connection electrode CE1: first connection layer CE2: second connection layer PE: pixel electrode
BM: Black Matrix CB: Chamber WT: Fluid MG: Magnet

### [Industrial applicability]

The embodiment may be adopted in the field of displays that display images or information.

The embodiment may be adopted in the field of displays that display images or information using semiconductor light-emitting devices.

The embodiment may be adopted in the field of displays that display images or information using micro- or nano-level semiconductor light-emitting devices.

## Claims

1. A display device including a semiconductor light emitting device comprising:
a substrate;
a first assembly wiring and a second assembly wiring alternately arranged on the substrate and spaced apart from each other;
an insulating layer disposed on the first assembly wiring or the second assembly wiring;
a planarization layer disposed on the first assembly wiring, the second assembly wiring and having an opening; and
a light emitting device disposed inside the opening, including a first electrode overlapping the first assembly wiring and the second assembly wiring,
wherein the first assembly wiring and the second assembly wiring are disposed on a same layer.

2. The display device including the semiconductor light emitting device according to claim 1, wherein the first electrode is bonded to one of the first assembly wiring or the second assembly wiring.

3. The display device including the semiconductor light emitting device according to claim 1, wherein the first assembly wiring comprises a first conductive layer disposed on the substrate; and a first clad layer in contact with the first conductive layer,
wherein the second assembly wiring comprises a second conductive layer disposed on the substrate; and a second clad layer in contact with the second conductive layer, and
wherein the first electrode is in contact with the second clad layer.

4. The display device including the semiconductor light emitting device according to claim 3, wherein the first conductive layer and the second conductive layer comprise the same material, and the first clad layer and the second clad layer comprise the same material.

5. The display device including the semiconductor light emitting device according to claim 3, wherein the first conductive layer and the second conductive layer are configured to overlap the planarization layer, and
wherein a portion of each of the first clad layer and the second clad layer is disposed inside the opening.

6. The display device including the semiconductor light emitting device according to claim 5, wherein the first clad layer and the first conductive layer are in contact with the insulating layer,
wherein the second clad layer and the second conductive layer are in contact with each other through the insulating layer.

7. The display device including the semiconductor light emitting device according to claim 6, wherein the first clad layer is disposed under the first conductive layer, and the second clad layer is disposed under the second conductive layer.

8. The display device including the semiconductor light emitting device according to claim 5, wherein the first clad layer is configured to cover the first conductive layer on the first conductive layer, and the second clad layer is configured to cover the second conductive layer on the second conductive layer.

9. The display device including the semiconductor light emitting device according to claim 5, further comprising a first insulating layer interposed between the side surface of the planarization layer overlapping the first conductive layer and the opening.

10. The display device including the semiconductor light emitting device according to claim 9, wherein the first clad layer and the second clad layer vertically overlap, and
wherein the second clad layer comprises an electrode hole in a region that vertically overlaps the first clad layer.

11. A display device including a semiconductor light emitting device comprising:
a substrate;
a first assembly wiring and a second assembly wiring alternately arranged on the substrate and spaced apart from each other;
an insulating layer disposed on the first assembly wiring or the second assembly wiring;
a planarization layer disposed on the first assembly wiring, the second assembly wiring and having an opening;
a light emitting device disposed inside the opening, including a first electrode overlapping the first assembly wiring and the second assembly wiring, and
a step protective layer overlapping the first assembly wiring or the second assembly wiring disposed below the insulating layer.

12. The display device including the semiconductor light emitting device according to claim 11, wherein the step protective layer is configured to overlap the planarization layer.

13. The display device including the semiconductor light emitting device according to claim 11, wherein the first assembly wiring comprises a first conductive layer and a first clad layer electrically connected to the first conductive layer,
wherein the second assembly wiring comprises a second conductive layer; and a second clad layer electrically connected to the second conductive layer,
wherein the first conductive layer and the first clad layer comprise different materials,
wherein the second conductive layer and the second clad layer comprise different materials.

14. The display device including the semiconductor light emitting device according to claim 12, wherein both the first clad layer and the second clad layer are configured to extend inside the opening.

15. The display device including the semiconductor light emitting device according to claim 13, wherein the first clad layer is configured to cover the first conductive layer, and the second clad layer is configured to cover the second conductive layer.

16. The display device including the semiconductor light emitting device according to claim 15, wherein the second conductive layer comprises the same material as the step protective layer.

17. The display device including the semiconductor light emitting device according to claim 13, wherein the first clad layer is disposed below the first conductive layer, and the second clad layer is disposed below the second conductive layer.

18. The display device including the semiconductor light emitting device according to claim 17, wherein the step protective layer is configured to cover the top and side surfaces of the first conductive layer.

19. The display device including the semiconductor light emitting device according to claim 13, further comprising a first insulating layer configured to be interposed between the side surface of the planarization layer overlapping the first conductive layer and the opening.

20. The display device including the semiconductor light emitting device according to claim 13, wherein the first clad layer and the second clad layer are configured to vertically overlap, and
wherein the second clad layer comprises an electrode hole in a region that vertically overlaps the first clad layer.
